Europäisches Patentamt

European Patent Office

Office européen des brevets

(11) Publication number: **0 213 336 B1**

# EUROPEAN PATENT SPECIFICATION

(45) Date of publication of patent specification: **02.05.91**   (51) Int. Cl.⁵: **H05K 3/20, H05K 3/46**

(21) Application number: **86109499.3**

(22) Date of filing: **11.07.86**

(54) Method for making a flush surface laminate for a multilayer circuit board.

(30) Priority: **26.08.85 US 769524**

(43) Date of publication of application:
**11.03.87 Bulletin 87/11**

(45) Publication of the grant of the patent:
**02.05.91 Bulletin 91/18**

(84) Designated Contracting States:
**CH DE FR GB IT LI NL SE**

(56) References cited:
**DE-A- 2 444 698**
**US-A- 3 161 945**
**US-A- 4 354 895**

**IBM TECHNICAL DISCLOSURE BULLETIN, vol.
21, no. 2, July 1978, pages 558,559, New York,
US; A.H. JOHNSON: "High conductivity
ground planes for epoxy board"**

(73) Proprietor: **International Business Machines
Corporation
Old Orchard Road
Armonk, N.Y. 10504(US)**

(72) Inventor: **Theron, La Rue Ellis
1176 Glenwood Road
Vestal New York 13850(US)**

(74) Representative: **Schröder, Otto H., Dr. Ing. et
al
IBM Corporation Säumerstrasse 4
CH-8803 Rüschlikon(CH)**

## Description

The present invention relates to a method for making a flush surface laminate for use in multilayer circuit boards and, more particularly, a method for making multilayer circuit boards consisting of such flush surface laminates.

In the manufacture of multilayer printed circuit boards for certain applications, e.g. in high-speed data processing apparatus, there is a need to make a more compact, higher speed board without sacrificing circuit density on the board. This can be accomplished using power core and/or signal core laminates to make a multilayer circuit board having an electrical resistance between layers of approximately 50 ohms rather than 80 ohms as provided with conventional circuit boards. However, using conventional printed circuit board manufacturing techniques, it is difficult, if not impossible to achieve this relatively low resistance circuit board structure within desired tolerances.

Also, conventional printed circuit board manufacturing techniques normally require chemical processing steps, such as applying photoresist, additively plating circuit lines or the like, and flash etching, which result in a "wet" process. However, for environmental and safety reasons, it is preferable to make circuit boards using "dry" processes, that is processes, such as plasma gas treatment and mechanical drilling, which do not involve chemical processing steps of the type associated with wet processes.

The following references are representative of the state of the art:

US Patent 4,354,895 generally relates to the construction of laminates for use in multilayer circuit boards of the type to which the present invention is directed. However, the patent relates to making the laminates using "wet" processes, such as applying photoresist, additively plating circuit lines or the like, and flash etching. In contrast, the present invention relates to a "dry" process (no chemical processing).

US Patents 4,030,190 and 3,791,858 as well as the articles "Multilayer Circuit Fabrication" (IBM Technical Disclosure Bulletin, Vol. 10, No. 4, pp. 359-360, September 1967) each generally relate to constructing a multilayer printed circuit board by a sequential process of building the circuit board up layer by layer. This sequential process is quite unlike the present invention which is directed to making a multilayer circuit board using a flush surface laminate which is laminated together with other such laminates to form the multilayer circuit board.

Article "Multilayer Laminated Circuit Construction" (IBM Technical Disclosure Bulletin, Vol. 7, No. 2, July 1964, pp. 154-155) relates to immobilizing spaced circuit elements on a circuit board by spreading a thixotropic (jelly-like) epoxy over the entire surface of the circuit board and then curing the epoxy to form a flush surface. A number of these circuit boards may be laminated together with a glass fiber spacer impregnated with an uncured resin to form a multilayer printed circuit board. This is quite unlike the present invention wherein a flush circuit laminate for a multilayer circuit board is formed using a "dry" process wherein a dielectric layer is sandwiched between two conductive layers to make the flush circuit laminate.

US Patent 3 161 945 discloses a method of making a printed circuit involving cutting and embedding a circuit pattern from a conductive foil into an insulating base sheet embodying a curable resin by applying heat and pressure. The conductive pattern is formed on one major surface of the insulating base sheet only.

Article "High Conductivity Ground Planes for Epoxy Board" (JMB Technical Disclosure Bulletin, Vol. 21, No. 2, July 1978, PP. 558-559) discloses a method of making a printed circuit board involving laminating a pair of drilled or punched copper sheets with resin therebetween which fills the hole cavities in the copper after lamination.

An object of the present invention is to provide a relatively simple and reliable method for manufacturing a multilayer circuit board having a desired relatively low electrical resistance between layers of the circuit board.

Another object of the present invention is to provide a method for manufacturing power core laminates for use in making a laminated multilayer circuit board having a desired relatively low electrical resistance between layers of the circuit board.

Still another object of the present invention is to provide a method, using dry processes, for manufacturing a multilayer circuit board having a desired relatively low electrical resistance between layers of the circuit board.

The invention as claimed is intended to meet these objects and to remedy the drawbacks hitherto encountered. In accordance with the present invention flush surface laminates may be made using dry processes and can then be assembled to form multilayer circuit boards. The laminates are obtained by sandwiching a sheet of dielectric material between two sheets of conductive material with each sheet of the conductive material having at least one opening extending therethrough between a first surface of the conductive sheet in contact with the dielectric material and a second surface of the conductive sheet forming an outside surface of the sandwich. Then, the sandwich of dielectric and conductive materials is positioned between a top plate and a bottom plate which are used to press the sandwich together while maintaining the sheets of dielectric and conductive material in registration with each other. The sandwich is pressed together between the top and the bottom plates at a temperature and pressure sufficient for the dielectric material to flow into the opening in the sheet of conductive material and form a flush surface laminate with the sheets of conductive material. Several such flush surface laminates may be made according to the foregoing method, in the form of power cores and the like, which then may be laminated together with flush surface signal cores and the like, to form the desired multilayer circuit board.

Flush surface laminates according to the present invention may be made thinner than conventional laminates used to construct multilayer circuit boards, while maintaining necessary dimensional tolerances. Thus, use of the flush surface laminates according to the present invention allows construction of a multilayer circuit board with a relatively low electrical resistance between layers of the circuit board thereby providing a relatively compact, high speed, multilayer circuit board without sacrificing circuit density on the board.

Other objects and advantages of the present invention will be apparent from the following description in conjunction with the accompanying drawings, wherein like reference numerals identify like elements, and in which:

Figure 1 is a cross-sectional view of part of a multilayer circuit board constructed according to the principles of the present invention by laminating together a flush surface power core between two flush surface signal cores.

Figure 2 is a cross-sectional view of the flush surface power core shown in Figure 1.

Figure 3 is a cross-sectional view of part of two sheets of conductive material, such as copper, each having drilled or pre-punched holes for use in making the flush surface power core shown in Figure 2 according to the principles of the present invention.

Figure 4 is a cross-sectional view of part of a sandwich structure, including the drilled or pre-punched copper sheets shown in Figure 3, which may be pressed together to form the flush surface power core shown in Figure 2, according to the principles of the present invention.

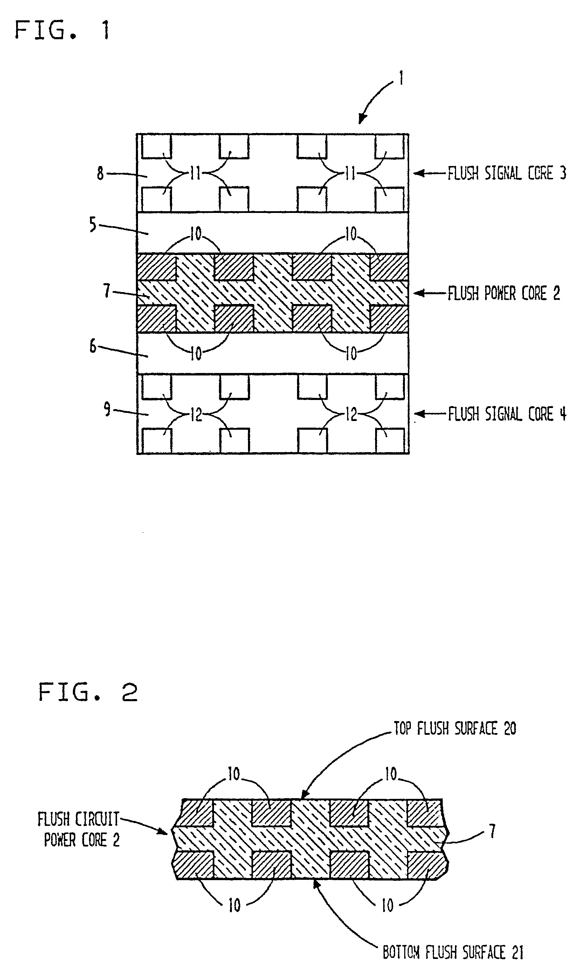

Referring to Figure 1, a cross-sectional view is shown of part of a multilayer circuit board 1 constructed by laminating together a flush surface power core 2 between a first (top) flush surface signal core 3 and a second (bottom) flush surface signal core 4 according to the principles of the present invention. As shown in Figure 1, there is a first (top) dielectric layer 5 separating the top flush surface signal core 3 from the power core 2 and a second (bottom) dielectric layer 6 separating the bottom flush surface signal core 4 from the power core 2. The dielectric layers 5 and 6 may comprise glass cloth impregnated with epoxy resin, or other such suitable material, which is cured during lamination with the signal cores 3 and 4, and the power core 2, to form the composite multilayer circuit board structure 1.

Also, as shown in Figure 1, the flush surface power core 2 comprises a dielectric material 7 having conductive material 10 embedded therein to form a power plane(s), or other such structure, for providing electrical power from a power supply (not shown) to the multilayer circuit board 1. In addition, as shown in Figure 1, the top flush surface signal core 3 comprises a dielectric material 8 having conductors 11 embedded therein to form electrical circuitry for providing desired electrical connections, such as electrical connections between electronic devices (not shown) which may be mounted on the multilayer circuit board 1. Similarly, the bottom flush surface signal core 4 comprises a dielectric material 9 having conductors 12 embedded therein to form electrical circuitry for providing desired electrical connections. Although not shown in Figure 1, it should be understood that, if desired, conductive vias (electrical connections) may be made between the power core 2 and the signal cores 3 and 4, or just between the signal cores 3 and 4. For example, such conductive vias may be made by drilling, or otherwise making, holes interconnecting certain of the conductors 11, and/or the conductors 12, with the conductive material 10 forming the power plane(s) of the multilayer circuit board 1, and then applying a coating of conductive material, such as copper, to the walls of the holes to provide electrical continuity between the conductors 11 and/or 12 and the conductive material 10 forming the power plane.

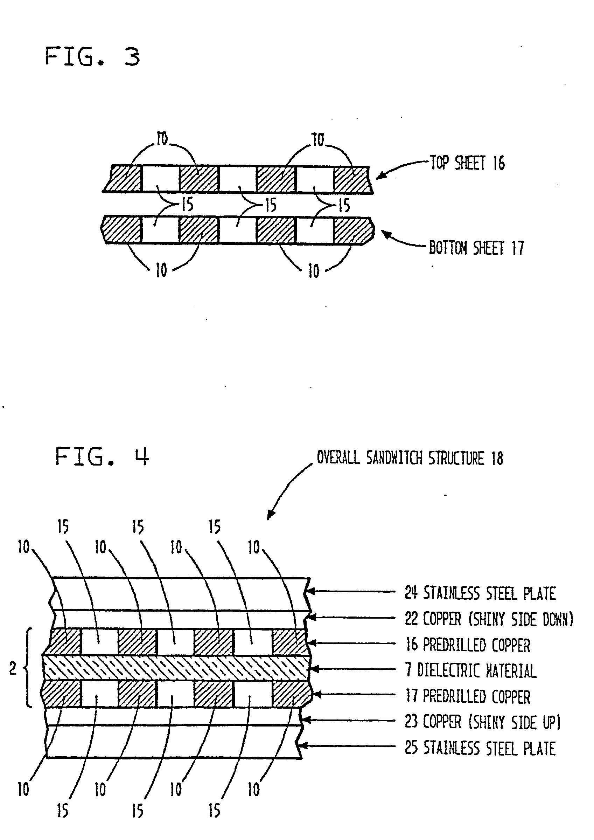

Referring to Figure 2, a cross-sectional view is shown of just the flush surface power core 2 shown in Figure 1 which is made according to the principles of the present invention. As shown in Figure 2, the power core 2 has a first (top) flush surface 20 and a second (bottom) flush surface 21. That is, the conductive material (power plane(s)) and the dielectric material 7 making up the power core 2 are substantially flush with each other on these outside surfaces 20 and 21 of the power core 2. The method for making this flush surface power core 2 according to the principles of the present invention is described in detail hereinafter with reference to Figures 3 and 4. However, it should be noted that while the following description is directed to making the power core 2, the method described is also suitable for making any other such flush surface laminate for any of a variety of purposes.

Now, referring to Figure 3, a cross-sectional view is shown of a first (top) sheet 16, and a second (bottom) sheet 17, each made of a conductive material, such as copper, having pre-punched or drilled holes (openings) 15 extending therethrough. These sheets 16 and 17 of conductive material are suitable for making the power plane(s) 10 of the flush surface power core 2 shown in Figures 1 and 2 according to a dry process as described below. Although pre-punching or drilling the holes 15 is preferred because these are dry processes, the holes 15 may be formed by any one of a variety of suitable processes including wet processes such as etching in a chemical etching bath, if desired.

As shown in Figure 3, the holes 15 in the conductive sheets 16 and 17 are intended as clearance holes for providing drill bit clearance when drilling vias (through holes) in the multilayer circuit board 1 between, for example, the top signal core 3 and the bottom signal core 4, as mentioned previously relative to Figure 1. Alternatively, the holes 15 may be locating holes for registration of the flush surface power core 2 with other laminates used, for example, to construct a multilayer circuit board 1 as shown in Figure 1. In fact, as will be readily apparent to one of ordinary skill in the art to which the present invention pertains, there are a variety of reasons for providing the holes 15 in the conductive sheets 16 and 17 which eventually become the conductive plane(s) 10 of the power core 2.

Figure 4 shows a partial cross-sectional view of an overall sandwich structure 18 which includes the drilled or pre-punched sheets 16 and 17 of conductive material shown in Figure 3, which may be pressed together with a sheet(s) of dielectric material 7 to form the flush surface power core 2 shown in Figures 1 and 2. The dielectric material 7 may be an unsupported film of a dielectric material, sheets of glass cloth impregnated with epoxy resin, commonly known as sheets of prepreg, or any other such suitable dielectric material. Alternatively, if desired, the dielectric material 7 may be a combination of sheets of different dielectric materials.

Also, as shown in Figure 4, the sandwich structure 18 comprises a first (top) sheet 22 of copper foil, and a second (bottom) sheet 23 of copper foil. The purpose of the copper foil sheets 22 and 23 is to act as release sheets so that the dielectric material 7 will not adhere to plates used in pressing the overall sandwich structure 18 together, such as plates 24, 25 shown in Figure 4. If the drilled or pre-punched sheets 16 and 17 are copper and the dielectric material 7 is glass cloth impregnated with epoxy resin, then, preferably, the sheets 22 and 23 are each made of sheets of one ounce copper foil having a smooth (shiny) side which faces the drilled or pre-punched copper sheets 16 and 17. However, it should be noted that, if desired, the sheets 22 and 23 may be made of polyvinylfluoride or any other material suitable for use as a release sheet.

Further, as shown in Figure 4, the overall sandwich structure 18 comprises a first, top plate 24 and a second, bottom plate 25. These plates 24 and 25 are used in pressing the sheets 7, 16 and 17 together at a temperature and pressure sufficient for the dielectric material 7 to flow into the holes 15 in the drilled or pre-punched sheets 16 and 17 of conductive material to form the desired flush surface power core 2 as shown in Figure 2. The plates 24 and 25 may be made of stainless steel or other such suitable material and a conventional laminating press (not shown) may be used to press the sandwich structure 18 together. The laminating press must be capable of pressing the sandwich structure 18 together at a temperature and pressure sufficient for the dielectric material 7 to flow into the holes (openings) 15 in the predrilled or pre-punched sheets 16 and 17 of conductive material to form the flush surface power core 2. The thickness of the dielectric material 7 is selected so that as a result of curing and lamination in laminating press, a desired spacing is provided between the pre-drilled or pre-punched sheets 16 and 17 of conductive material thereby producing a desired impedance characteristic for the resulting flush surface power core 2.

After the pressing operation is completed, the finished flush surface power core 2 is removed from the laminating press ready for use in constructing a multilayer circuit board 1 as shown in Figure 1. However, preferably, to enhance adhesion of the flush surface power core 2 to other laminates used in constructing the multilayer circuit board 1, the flush surfaces 20 and 21 (see Figure 2) of the power core 2 are roughened by, for example, a plasma etching process which is a dry process. Of course, if desired, a wet roughening process may be used.

The foregoing described process for making a flush surface laminate, such as the power core 2 shown in Figure 2, for use in constructing a circuit board, such as the multilayer circuit board 10 shown in Figure 1, has several advantages over conventional methods of making laminates for use in constructing multilayer circuit boards. For example, a substantially thinner multilayer circuit board may be constructed using flush surface laminates according to the present invention, while still maintaining dimensional tolerances necessary to attain desired impedance characteristics for the multilayer circuit board. In part, such a relatively thin multilayer circuit board structure is possible according to the present invention because, for example, the dielectric layers 5 and 6 shown in Figure 1, are not required to fill clearance holes, flow around signal lines, or perform other such functions, when making the multilayer circuit board 1. Thus, substantially less dielectric material may used in the dielectric layers 5 and 6 while still maintaining dimensional tolerances necessary to attain desired electric characteristics for the resulting multilayer circuit board structure. This feature is very important since a thinner multilayer circuit board according to the present invention results in a more compact, higher speed circuit board without sacrificing performance capabilities. For example, higher speed results from electrical signals having shorter distances to travel between, for example, signal planes of the relatively thin multilayer circuit board according to the present invention.

In addition to the foregoing, there are many other advantages of flush surface laminates according to the present invention. For example, if desired, the flush surface laminates of the present invention may be made using all dry processes. As mentioned above, use of such dry processes is preferred from environmental and safety viewpoints. Also, the possibility of internal voids is reduced when making a multilayer circuit board using flush surface laminates according to the present invention since the circuit boards are thinner for the same performance capability when compared to conventional multilayer circuit boards. Further, thinner multilayer circuit boards according to the present invention are easier to drill, for example, when drilling through holes in the circuit board.

Of course, the foregoing description is directed to one particular embodiment of the present invention and various modifications and other embodiments of the present invention will be apparent to one of ordinary skill in the art to which the present invention pertains.

## Claims

1. A method for making a flush surface laminate (2) with completely flush surfaces for a multilayer circuit board (1), comprising the steps of:
   - sandwiching a sheet of dielectric material (7) between two sheets (16, 17) of conductive material, each sheet of the conductive material having at least one opening (15) extending therethrough between a first surface of the conductive sheet in contact with the dielectric material and a second surface of the conductive sheet forming an outside surface of the sandwich, the thickness of said dielectric material being selected such that, in the completed laminate structure, a desired spacing is provided between the two sheets of conductive material to produce a desired low characteristic impedance;
   - placing release sheets (22, 23) on the outside surfaces of the sandwich (2) of dielectric and conductive materials;
   - positioning the sandwich of dielectric (7) and conductive (16, 17) materials with the release sheets (22, 23) on the outside surfaces between a top plate (24) and a bottom plate (25) which may be used to press the sandwich together while maintaining the sheets of dielectric and conductive material in registration with each other; and
   - pressing the sandwich together between the top (24) and the bottom (25) plates at a temperature and pressure sufficient for the dielectric material (7) to flow into the openings (15) in the sheets (16, 17) of conductive material and form a completely flush surface laminate with the sheets of conductive material.

2. The method as recited in claim 1 further comprising the step of:
   - roughening the flush surface (20, 21) of the laminate (2).

3. The method as recited in claim 2 wherein the step of roughening comprises:
   - plasma etching the flush surface of the laminate.

4. The method as recited in claim 1 wherein the conductive material comprises copper.

5. The method as recited in claim 1 wherein the dielectric material comprises glass cloth impregnated with an epoxy resin.

6. A method for making a multilayer circuit board (1) comprising the steps of:
   - producing a first flush surface laminate (2) with completely flush surfaces by
     * forming a sandwich by placing a sheet of dielectric material (7) between two sheets (16, 17) of conductive material, each sheet of the conductive material having at least one opening (15) extending therethrough between a first surface of the conductive sheet in contact with the dielectric material and a second surface of the conductive sheet forming an outside surface of the sandwich, the thickness of said dielectric material being selected such that, in the completed laminate structure, a desired spacing is provided between the two sheets of conductive material to produce a desired low characteristic impedance;

• placing release sheets (22, 23) on the outside surfaces of the sandwich (2) of dielectric and conductive materials;

• positioning the sandwich of dielectric (7) and conductive (16, 17) materials with the release sheets (22, 23) on the outside surfaces between a top plate (24) and a bottom plate (25) which may be used to press the sandwich together while maintaining the sheets of dielectric and conductive material in registration with each other;

• pressing the sandwich together between the top (24) and the bottom (25) plates at a temperature and pressure sufficient for the dielectric material (7) to flow into the openings (15) in the sheets (16, 17) of conductive material and form a first completely flush surface laminate with the sheets of conductive material;

- producing a second flush surface laminate (3) in a process corresponding to that used to produce the first laminate (2);

- placing a further layer of dielectric material (5) between the first (2) and the second (3) flush surface laminates; and

- pressing the first (2) and the second (3) flush surface laminates together at a temperature and pressure sufficient to form the multilayer circuit board

7. The method as recited in claim 6 further comprising the step of:

- roughening the flush surfaces of the first (2) and the second (3) flush surface laminates before the step of pressing these laminates together to form the multilayer laminate.

8. The method as recited in claim 7 wherein the step of roughening comprises:

- plasma etching the flush surfaces of the first and the second flush surfaces (2, 3).

**Revendications**

1. Procédé pour fabriquer un stratifié (2) à surfaces lisses, comportant des surfaces entièrement lisses pour une plaquette à circuits imprimés à couches multiples (1), incluant les étapes consistant à :

- insérer, en formant une structure sandwich, une feuille d'un matériau diélectrique (7) entre deux feuilles (16, 17) formé d'un matériau conducteur, chaque feuille formée du matériau conducteur possédant au moins une ouverture (15) la traversant entre une première surface de la feuille conductrice en contact avec le matériau diélectrique et une seconde surface de la feuille conductrice formant une surface extérieure du dispositif à structure sandwich, l'épaisseur dudit matériau diélectrique étant choisie de manière que, dans la structure stratifiée terminée, un espace désiré est ménagé entre les deux feuilles formées du matériau conducteur pour l'obtention d'une faible impédance caractéristique désirée;

- mettre en place des feuilles de détachement (22,23) sur les surfaces extérieures de la structure sandwich (2) formée du matériau diélectrique et du matériau conducteur;

- disposer la structure sandwich formée du matériau diélectrique (7) et du matériau conducteur (16,17), sur les surfaces extérieures desquelles sont disposées les feuilles de détachement (22,23), entre une plaque supérieure (24) et une plaque inférieure (25), qui peuvent être utilisées pour comprimer la structure sandwich tout en maintenant les feuilles du matériau diélectrique et des matériaux conducteurs, alignées entre elles; et

- serrer la structure sandwich contre la plaque supérieure (24) et la plaque inférieure (25) à une température et à une pression suffisantes pour que le matériau diélectrique (7) pénètre dans les ouvertures (15) ménagées dans les feuilles (16,17) formées du matériau conducteur et forme un stratifié incluant les feuilles formées du matériau conducteur à surfaces entièrement lisses.

2. Procédé selon la revendication 1, incluant en outre l'étape consistant à:

rendre rugeuse la surface lisse (20,21) du stratifié (2).

3. Procédé selon la revendication 2, selon lequel l'étape de formation d'une rugosité inclut:

- la corrosion plasmatique de la surface lisse du stratifié.

**4.** Procédé selon la revendication 1, selon lequel le matériau conducteur est formé de cuivre.

**5.** Procédé selon la revendication 1, selon lequel le matériau diélectrique est formé d'un tissu de verre imprégné d'une résine époxy.

**6.** Procédé pour fabriquer une plaquette à circuits imprimés à couches multiples (1), incluant les étapes consistant à :
- fabriquer un premier stratifié (2) à surfaces lisses, qui comporte des surfaces entièrement lisses, moyennant
  - la formation d'une structure sandwich moyennant l'insertion d'un feuille formée d'un matériau diélectrique (7) entre deux feuilles (16,17) formées d'un matériau conducteur, chaque feuille formée du matériau conducteur possédant au moins une ouverture (15) la traversant entre une première surface de la feuille conductrice en contact avec le matériau diélectrique et une seconde surface de la feuille conductrice formant une surface extérieure du dispositif à structure sandwich, l'épaisseur dudit matériau diélectrique étant choisie de manière que, dans la structure stratifiée terminée, un espace désiré est ménagé entre les deux feuilles formées du matériau conducteur pour l'obtention d'une faible impédance caractéristique désirée;
  - la mise en place de feuilles de détachement (22,23) sur les surfaces extérieures de la structure sandwich (2) formées du matériau diélectrique et du matériau conducteur;
  - la mise en place de la structure sandwich formée du matériau diélectrique (7) et du matériau conducteur (16, 17), sur les surfaces extérieures desquelles sont disposées les feuilles de détachement (22,23), entre une plaque supérieure et une plaque inférieure (25), qui peuvent être utilisées pour comprimer la structure sandwich tout en maintenant les feuilles formées du matériau diélectrique et du matériau conducteur, alignées entre elles;
  - le serrage de la structure sandwich contre la plaque supérieure (24) et la plaque inférieure (25) à une température et à une pression suffisantes pour que le matériau diélectrique (7) pénètre dans les ouvertures (15) ménagées dans les feuilles (16,17) formées du matériau conducteur et forme un stratifié incluant les feuilles formées du matériau conducteur à surfaces entièrement lisses;
- fabriquer un second substrat stratifié (3) à surfaces lisses au moyen d'un procédé correspondant à celui utilisé pour fabriquer le premier stratifié (2);
- mettre en place une autre couche d'un matériau diélectrique (5) entre les premier et second stratifiés (2,3) à surfaces lisses;
- serrer les premier et second stratifiés (2,3) à surfaces lisses, à une température et une pression suffisantes pour former une plaquette à circuits imprimés à couches multiples.

**7.** Procédé selon la revendication 6, incluant en outre l'étape consistant à :
rendre rugueuses les surfaces lisses des premier et second stratifiés (2,3) à surfaces lisses avant l'étape de serrage de ces stratifiés ensemble pour former le stratifié à couches multiples.

**8.** Procédé selon la revendication 7, selon lequel l'étape servant à créer une rugosité inclut:
- la corrosion plasmatique des surfaces lisses des premier et second stratifiés (2,3) à surfaces lisses.

**Ansprüche**

**1.** Verfahren zur Herstellung eines ebenflächigen Laminates mit vollständig ebenen Oberflächen für eine Mehrlagen - Leiterplatte (1), bestehend aus den folgenden Schritten:
- Schichten eines Blattes aus dielektrischem Material (7) zwischen zwei Blättern (16, 17) aus leitfähigem Material, wobei jedes Blatt aus leitfähigem Material zumindest eine Öffnung (15) besitzt, die sich durch dieses hindurch zwischen einer ersten, in Kontakt mit dem dielektrischen Material stehenden Oberfläche des leitfähigen Blattes und einer zweiten, eine äußere Oberfläche des Sandwich bildenden Oberfläche erstreckt, und die Stärke des dielektrischen Materials so gewählt ist, daß bei der fertiggestellten Laminatstruktur ein gewünschter Abstand zwischen den beiden Blättern aus leitfähigem Material gewährleistet ist, um eine gewünschte niedrige charakteristische Impedanz zu erzielen,
- Anbringen von Trennblättern (22, 23) an den äußeren Oberflächen des Sandwich (2) aus dielektrischen und leitfähigen Materialien,

- Anordnen des Sandwich aus dielektrischen (7) und leitfähigen (16, 17) Materialien samt den Trennblättern (22, 23) an den äußeren Oberflächen zwischen einer oberen Platte (24) und einer unteren Platte (25), die verwendet werden können, um das Sandwich zusammenzupressen, während die Blätter aus dielektrischem und leitfähigem Material gegeneinander ausgerichtet bleiben, und

- Zusammenpressen des Sandwich zwischen der oberen (24) und unteren (25) Platte bei einer Temperatur und einem Druck, die hinreichend sind, das dielektrische Material (7) in die Öffnungen (15) der Blätter (16, 17) aus leitfähigem Material fliessen zu lassen und mit den Blättern aus leitfähigem Material ein Laminat mit vollständig ebener Oberfläche zu bilden.

2. Verfahren nach Anspruch 1, welches darüberhinaus die folgenden Schritte aufweist:
   - Aufrauhen der ebenen Oberfläche (20, 21) des Laminats (2).

3. Verfahren nach Anspruch 2, bei welchem der Schritt des Aufrauhens beinhaltet:
   - Plasmaätzen der ebenen Oberfläche des Laminats.

4. Verfahren nach Anspruch 1, bei welchem das leitfähige Material Kupfer enthält.

5. Verfahren nach Anspruch 1, bei welchem das dielektrische Material mit Epoxyharz imprägniertes Glasgewebe enthält.

6. Verfahren zur Herstellung einer mehrschichtigen Leiterplatte (1), welches die folgenden Schritte aufweist:
   - Herstellen eines ersten ebenflächigen Laminats (2) mit vollständig ebenen Oberflächen durch:
     • Bildung eines Sandwich durch Anordnen eines Blattes aus dielektrischem Material (7) zwischen zwei Blättern (16, 17) aus leitfähigem Material, wobei jedes Blatt aus leitfähigem Material zumindest eine Öffnung (15) besitzt, die sich durch dieses hindurch zwischen einer ersten, in Kontakt mit dem dielektrischen Material stehenden Oberfläche des leitfähigen Blattes und einer zweiten, eine äußere Oberfläche des Sandwich bildenden Oberfläche erstreckt, und die Stärke des dielektrischen Materials so gewählt ist, daß bei der fertig gestellten Laminatsturktur ein gewünschter Abstand zwischen den beiden Blättern aus leitfähigem Material gewährleistet ist, um eine gewünschte niedrige charakteristische Impedanz zu erzielen,
     • Anbringen von Trennblättern (22, 23) an den äußeren Oberflächen des Sandwich (2) aus dielektrischen und leitfähigen Materialien,
     • Anordnen des Sandwich aus dielektrischen (7) und leitfähigen (16, 17) Materialien samt den Trennblättern (22, 23) an den äußeren Oberflächen zwischen einer oberen Platte (24) und einer unteren Platte (25), die verwendet werden können, um das Sandwich zusammenzupressen, während die Blätter aus dielektrischem und leitfähigem Material gegeneinander ausgerichtet bleiben,
     • Zusammenpressen des Sandwich zwischen der oberen (24) und unteren (25) Platte bei einer Temperatur und einem Druck, die hinreichend sind, das dielektrische Material (7) in die Öffnungen (15) der Blätter (16, 17) aus leitfähigem Material fliessen zu lassen und mit den Blättern aus leitfähigem Material ein erstes Laminat mit vollständig ebener Oberfläche zu bilden,
   - Herstellen eines zweiten ebenflächigen Laminats (3) nach einem Verfahren wie jenem zur Herstellung des erten Laminats (2),
   - Anordnen einer weiteren Schicht aus dielektrischem Material (5) zwischen dem ersten (2) und dem zweiten (3) ebenflächigen Laminat, und
   - Zusammenpressen des ersten (2) und des zweiten (3) ebenflächigen Laminats bei einer Temperatur und einem Druck die hinreichend sind, um die mehrschichtige Leiterplatte zu bilden.

7. Verfahren nach Anspruch 6, welches darüberhinaus den folgenden Schritt beinhaltet:
   - Aufrauhen der ebenen Oberflächen des ersten (2) und des zweiten (3) ebenflächigen Laminats vor dem Schritt des Zusammenpressens dieser Laminate zur Bildung des mehrschichtigen Laminats.

8. Verfahren nach Anspruch 7, bei welchem der Schritt des Aufrauhens beinhaltet:

- Plasmaätzen der ebenen Oberflächen der ersten und zweiten ebenen Oberflächen (2, 3).

## FIG. 1

8 ← FLUSH SIGNAL CORE 3

11        11

5

10        10

7 ← FLUSH POWER CORE 2

6

10        10

9 ← FLUSH SIGNAL CORE 4

12        12

## FIG. 2

TOP FLUSH SURFACE 20

10        10

FLUSH CIRCUIT POWER CORE 2

7

10        10

BOTTOM FLUSH SURFACE 21

10

# FIG. 3

TOP SHEET 16

BOTTOM SHEET 17

# FIG. 4

OVERALL SANDWITCH STRUCTURE 18

24 STAINLESS STEEL PLATE
22 COPPER (SHINY SIDE DOWN)
16 PREDRILLED COPPER
7 DIELECTRIC MATERIAL
17 PREDRILLED COPPER
23 COPPER (SHINY SIDE UP)
25 STAINLESS STEEL PLATE